# EUROPEAN PATENT APPLICATION

(11) **EP 4 355 039 A1**
(43) Date of publication of application: **17.04.2024**
(21) Application number: 21944710.9
(22) Date of filing: 30.06.2021
(51) Int. Cl.: H05K 3/00

(54) **CIRCUIT BOARD AND BACK DRILLING PROCESSING METHOD**

(30) Priority: 11.06.2021 CN 202110655494
(71) Applicant: Shennan Circuits Co., Ltd., Shenzhen City, Guangdong 518117 (CN)
(72) Inventor: LIN, Dantian, Shenzhen, Guangdong 518117 (CN); DU, Yufang, Shenzhen, Guangdong 518117 (CN); HAN, Xuechuan, Shenzhen, Guangdong 518117 (CN); LIU, Hailong, Shenzhen, Guangdong 518117 (CN); WU, Jie, Shenzhen, Guangdong 518117 (CN)
(74) Representative: Herrero & Asociados, S.L.
(86) International application number: PCT/CN2021/103814
(87) International publication number: WO 2022/257204

(57) **Abstract**

A back drilling processing method for a circuit board. The processing method comprises: obtaining a board to be back drilled, wherein said board comprises a target signal layer and at least two conductive reference layers, and the target signal layer is a signal layer corresponding to the current back drilling task; drilling a through hole at a set position of said board, and obtaining an actually measured spacing between two conductive reference layers of said board on the basis of the through hole; in response to a back drilling hole to be back drilled being of a first type, determining a target back drilling depth on the basis of the actually measured spacing; controlling a back drilling bit to drill the back drilling hole of the target back drilling depth towards the target signal layer, with the back drilling not drill through the target signal layer; in response to the back drilling hole to be back drilled being of a second type, determining a target relative height of a back drilling end point relative to a machine on the basis of the actually measured spacing; and controlling the back drilling bit to drill the back drilling hole of the target relative height towards the target signal layer, with the back drilling not drill through the target signal layer. The actually measured spacing between two conductive reference layers corresponding to the hole to be back drilled is obtained when the through hole is drilled, and the target back drilling depth and the target relative height are determined for different types of holes to be back drilled on the basis of the actually measured spacing, such that the accuracy of the target back drilling depth or the target relative height is improved; the back drilling is performed on the basis of the target back drilling depth or the target relative height, such that the drilling error caused by non-uniform board thickness at different positions of a circuit board is reduced and the precision of back drilling for the circuit board is improved.

## Description

### TECHNICAL FIELD

The present disclosure relates to the field of circuit boards, and in particular to a circuit board and a back drilling processing method.

### BACKGROUND

As the information industry promotes, a speed of transmitting digital signals is increasingly faster, a frequency of transmitting digital signals is increasing higher, and it is increasing critical to ensure integrity of the signals. A copper portion of a metal via in the circuit board that is not for signal transmission and is useless may increase a loss in signal transmission. When the frequency of the signals of the circuit increases to a certain extent, the useless copper plated in the via serves as an antenna and generates signal radiation that interferes with other surrounding signals. In some serious cases, the integrity of the transmitted signals may be affected. Therefore, the excessive plated copper may be drilled off as much as possible by performing back drilling processing, such that an impact, caused by the excessive plated copper, on the signal transmission of the metal vias may be reduced.

In the art, a predetermined back-drilling depth is predetermined in advance. Subsequently, the metal via is back-drilled based on the predetermined back-drilling depth to remove the excessive plated copper in the metal via. However, in practice, due to uneven dielectric thickness and inner layer pattern design, accuracy of back drilling to remove the residual copper based on the predetermined back-drilling depth is insufficient, resulting in a large signal loss in the signal via, such that high-frequency and high-speed performance of the product cannot be satisfied.

Therefore, improving accuracy of back drilling is a challenge in processing the circuit board.

### SUMMARY OF THE DISCLOSURE

The present disclosure provides a circuit board and a back drilling processing method to solve the problem of the accuracy of back drilling to remove the residual stub being insufficient.

In a first aspect, the present disclosure provides a back drilling processing method for a circuit board, including: obtaining a to-be-back-drilled board, wherein the to-be-back-drilled board comprises a target signal layer and at least two conductive reference layers; the target signal layer is a signal layer corresponding to a current back-drilling operation; drilling a through hole at a predetermined position of the to-be-back-drilled board; obtaining, based on the through hole, a measured spacing between two of the at least two conductive reference layers of the to-be-back-drilled board; determining, in response to a to-be-back-drilled via being of a first type, a target back-drilling depth based on the measured spacing; controlling a drilling bit to drill for the target back-drilling depth towards the target signal layer to obtain a back-drilled via without penetrating through the target signal layer; and determining, in response to the to-be-back-drilled via being of a second type, a target relative height from an end point of back drilling to a machine based on the measured spacing; controlling the drilling bit to drill towards the target signal layer for the target relative height to obtain the back-drilled via without penetrating through the target signal layer.

In some embodiments, the method further includes: obtaining a predetermined back-drilling depth of the to-be-back-drilled via in the to-be-back-drilled board; determining, in response to the predetermined back-drilling depth being greater than or equal to a signal detection safety value, that the to-be-back-drilled via is of the first type; determining, in response to the predetermined back-drilling depth being less than the signal detection safety value, that the to-be-back-drilled via is of the second type.

In some embodiments, the to-be-back-drilled board includes a first conductive reference layer, a second conductive reference layer, and a third conductive reference layer; the first conductive reference layer is a first surface conductive layer disposed on a side of the to-be-back-drilled board from which the drilling bit drills, the second conductive reference layer is disposed between the first surface conductive layer and the target signal layer, and the third conductive reference layer is a second surface conductive layer of the to-be-back-drilled board. The drilling a through hole at a predetermined position of the to-be-back-drilled board; obtaining, based on the through hole, a measured spacing between two of the at least two conductive reference layers of the to-be-back-drilled board, includes: drilling from the second surface conductive layer at the predetermined position of the to-be-back-drilled board to obtain the through hole; and obtaining a measured spacing between the second surface conductive layer and the second conductive reference layer. The determining, in response to the to-be-back-drilled via being of a second type, a target relative height from an end point of back drilling to a machine based on the measured spacing; controlling the drilling bit to drill towards the target signal layer for the target relative height to obtain the back-drilled via without penetrating through the target signal layer, includes: determining, based on the measured spacing between the second surface conductive layer and the second conductive reference layer, the target relative height from the end point of the back drilling to the machine in response to the to-be-back-drilled via being of the second type; and controlling the drilling bit to enter the to-be-back-drilled board from the first surface conductive layer to drill towards the target signal layer, drilling for the target relative height, to obtain the back-drilled via, wherein the target signal layer is not penetrated through by back drilling.

In some embodiments, the determining, based on the measured spacing between the second surface conductive layer and the second conductive reference layer, the target relative height from the end point of the back drilling to the machine in response to the to-be-back-drilled via being of the second type, includes: determining, based on the measured spacing between the second surface conductive layer and the second conductive reference layer and a predetermined staged-controlled depth from the second conductive reference layer to the target signal layer, the target relative height from the end point of back drilling to the machine in response to the to-be-back-drilled via being of the second type.

In some embodiments, a pad is arranged on a side of the to-be-back-drilled board where the second surface conductive layer is disposed. The determining, based on the measured spacing between the second surface conductive layer and the second conductive reference layer, the target relative height from the end point of back drilling to the machine in response to the to-be-back-drilled via being of the second type, includes: determining the target relative height from the end point of back drilling to the machine based on the measured spacing between the second surface conductive layer and the second conductive reference layer, the predetermined staged-controlled depth from the second conductive reference layer to the target signal layer, and a height from the pad to the machine.

In some embodiments, the determining, based on the measured spacing between the second surface conductive layer and the second conductive reference layer, the target relative height from the end point of back drilling to the machine in response to the to-be-back-drilled via being of the second type, includes: determining the target relative height from the end point of back drilling to the machine by subtracting the predetermined staged-controlled depth from the second conductive reference layer to the target signal layer from a sum of the height from the pad to the machine, the measured spacing between the second surface conductive layer and the second conductive reference layer, and a compensation value.

In some embodiments, the to-be-back-drilled board includes a first conductive reference layer and a second conductive reference; the first conductive reference layer is a first surface conductive layer disposed on a side of the to-be-back-drilled board from which the drilling bit drills; the second conductive reference layer is disposed between the first surface conductive layer and the target signal layer. The drilling a through hole at a predetermined position of the to-be-back-drilled board; obtaining, based on the through hole, a measured spacing between two of the at least two conductive reference layers of the to-be-back-drilled board, includes: drilling the through hole at the predetermined position of the to-be-back-drilled board; and obtaining, based on the through hole, a measured spacing between the first surface conductive layer and the second conductive reference layer of the to-be-back-drilled board. The determining, in response to a to-be-back-drilled via being of a first type, a target back-drilling depth based on the measured spacing; controlling a drilling bit to drill for the target back-drilling depth towards the target signal layer to obtain a back-drilled via without penetrating through the target signal layer, includes: determining the target back-drilling depth, in response to the to-be-back-drilled via being of the first type, based on the measured spacing between the first surface conductive layer and the second conductive reference layer of the to-be-back-drilled board; controlling the drilling bit to drill from the first surface conductive layer towards the target signal layer, drilling for the target back-drilling depth, to obtain the back-drilled via, wherein the target signal layer is not penetrated through by the back drilling.

In some embodiments, the determining the target back-drilling depth, in response to the to-be-back-drilled via being of the first type, based on the measured spacing between the first surface conductive layer and the second conductive reference layer of the to-be-back-drilled board, includes: determining, based on the measured spacing between the first surface conductive layer and the second conductive reference layer and a predetermined staged-controlled depth from the second conductive reference layer to the target signal layer, the target back-drilling depth in response to the to-be-back-drilled via being of the first type.

In some embodiments, the to-be-back-drilled board further comprises a second surface conductive layer. The drilling a through hole at a predetermined position of the to-be-back-drilled board; obtaining, based on the through hole, a measured spacing between two of the at least two conductive reference layers of the to-be-back-drilled board, includes: drilling the through hole at the predetermined position of the to-be-back-drilled board; and obtaining, based on the through hole, the measured spacing between the first surface conductive layer and the second conductive reference layer of the to-be-back-drilled board, and the measured spacing between the first surface conductive layer and the second surface conductive layer of to-be-back-drilled board. The determining the target back-drilling depth, in response to the to-be-back-drilled via being of the first type, based on the measured spacing between the first surface conductive layer and the second conductive reference layer of the to-be-back-drilled board, includes: obtaining a board thickness ratio based on the measured spacing between the first surface conductive layer and the second surface conductive layer and a theoretical board thickness of the to-be-back-drilled board; and in response to the to-be-back-drilled via being of the first type, determining the target back-drilling depth based on a sum of a first product and a sum of the measured spacing between the first surface conductive layer and the second conductive reference layer, wherein the first product is the predetermined staged-controlled depth from the second conductive reference layer to the target signal layer multiplied by the board thickness ratio.

In some embodiments, the to-be-back-drilled board further comprises a third conductive reference layer and a second surface conductive layer, the third conductive reference layer is disposed between the second surface conductive layer and the target signal layer. The drilling a through hole at a predetermined position of the to-be-back-drilled board; obtaining, based on the through hole, a measured spacing between two of the at least two conductive reference layers of the to-be-back-drilled board, includes: drilling the through hole at the predetermined position of the to-be-back-drilled board; obtaining, based on the through hole, the measured spacing between the first surface conductive layer and the second conductive reference layer, a measured spacing between the second conductive reference layer and the third conductive reference layer, and a measured spacing between the second surface conductive layer and the third conductive reference layer. The determining, based on the measured spacing between the first surface conductive layer and the second conductive reference layer and a predetermined staged-controlled depth from the second conductive reference layer to the target signal layer, the target back-drilling depth in response to the to-be-back-drilled via being of the first type, includes: in response to the to-be-back-drilled via being of the first type, obtaining an inter-layer ratio based on the measured spacing between the second conductive reference layer and the third conductive reference layer and a theoretical spacing between the second conductive reference layer and the third conductive reference layer; and determining a first target back-drilling depth based on a sum of a first product and the measured spacing between the first surface conductive layer and the second conductive reference layer, wherein the first product is the predetermined staged-controlled depth from the second conductive reference layer to the target signal layer multiplied by the inter-layer ratio. Controlling the drilling bit to drill from the first surface conductive layer towards the target signal layer, drilling for the target relative height, without penetrating through the target signal layer, includes: controlling the drilling bit to drill from the first surface conductive layer to the target signal layer, drilling for the first target back-drilling depth, to obtain the back-drilled via, wherein the target signal layer is not penetrated through by the back drilling.

In some embodiments, the determining, based on the measured spacing between the first surface conductive layer and the second conductive reference layer and a predetermined staged-controlled depth from the second conductive reference layer to the target signal layer, the target back-drilling depth in response to the to-be-back-drilled via being of the first type, includes: determining a second target back-drilling depth based on a sum of a second product and the measured spacing between the second surface conductive layer and the third conductive reference layer, wherein the second product is a predetermined staged-controlled depth from the third conductive reference layer to the target signal layer multiplied by the inter-layer ratio. Controlling the drilling bit to drill towards the target signal layer for the target back-drilling depth to obtain the back-drilled via without penetrating through the target signal layer, includes: controlling the drilling bit to drill from the second surface conductive layer towards the target signal layer, drilling for the second target back-drilling depth, to obtain the back-drilled via, wherein the target signal layer is not penetrated through by the back drilling.

In some embodiments, the measured spacing between the second conductive reference layer and the third conductive reference layer is greater than or equal to a signal detection safety value.

In some embodiments, the to-be-back-drilled board comprises a plurality of to-be-back-drilled vias. The obtaining a to-be-back-drilled board, wherein the to-be-back-drilled board comprises a target signal layer and at least two conductive reference layers; the target signal layer is a signal layer corresponding to a current back-drilling operation, includes: obtaining the to-be-back-drilled board, wherein each of the plurality of to-be-back-drilled vias corresponds to one target signal layer and at least two conductive reference layers; and the target signal layer is a signal layer corresponding to the current back-drilling operation.

In some embodiments, the drilling a through hole at a predetermined position of the to-be-back-drilled board; obtaining, based on the through hole, a measured spacing between two of the at least two conductive reference layers of the to-be-back-drilled board, includes: drilling one through hole at a predetermined position corresponding to each of the plurality of to-be-back-drilled vias; and obtaining a measured spacing of two of the at least two conductive reference layers for each of the plurality of to-be-back-drilled vias

In some embodiments, after the drilling a through hole at a predetermined position of the to-be-back-drilled board; obtaining, based on the through hole, a measured spacing between two of the at least two conductive reference layers of the to-be-back-drilled board, the method further includes: performing metallization on the through hole to obtain a metal hole.

In some embodiments, the controlling the drilling bit to drill towards the target signal layer for the target back-drilling depth to obtain the back-drilled via without penetrating through the target signal layer, includes: controlling drilling bit to drill, at a position where the metal hole is disposed, towards the target signal layer, drilling for the target back-drilling depth, to obtain the back-drilled via without penetrating through the target signal layer.

In some embodiments, the controlling the drilling bit to drill towards the target signal layer for the target relative height to obtain the back-drilled via without penetrating through the target signal layer, includes: controlling drilling bit to drill, at the position where the metal hole is disposed, towards the target signal layer, drilling for the target relative height, to obtain the back-drilled via without penetrating through the target signal layer.

In some embodiments, the target relative height from the end point of back drilling to the machine is a longitudinal coordinate of the end point of back drilling in a coordinate system of the machine.

In some embodiments, the signal detection safety value is greater than or equal to 0.5 mm.

In a second aspect, the present disclosure provides a circuit board, obtained by performing the back drilling processing method according to any of the above embodiment.

According to the present disclosure, a method of back drilling to process the circuit board is provided. In the method, the to-be-back-drilled board is obtained. The to-be-back-drilled board includes the target signal layer and at least two conductive reference layers. The target signal layer is a signal layer corresponding to a current back-drilling operation. A through hole is defined by drilling the to-be-back-drilled board at a predetermined position, and a measured spacing between the two conductive reference layers of the to-be-back-drilled board is obtained based on the through hole. A target back-drilling depth is determined based on the measured spacing in response to the to-be-back-drilled via being of a first type. The back-drilling bit is controlled to drill the target signal layer for the target back-drilling depth to obtain the back-drilled hole, and the target signal layer is not drilled through by the back drilling. A target relative height between the end point of the back drilling and the machine is determined based on the measured spacing in response to the to-be-back-drilled via being of a second type. The back-drilling bit is controlled to drill towards the target signal layer for the target relative height to obtain the back-drilled via, and the target signal layer is not drilled through by the back drilling. Since the measured spacing between the two conductive reference layers corresponding to the to-be-back-drilled via is obtained when drilling the through hole and the target back-drilling depth or the target relative height for different types of to-be-back-drilled vias are determined based on measured spacing, the accuracy of the target back-drilling depth or the target relative height is improved. The back drilling is performed based on the target back-drilling depth or the target relative height. Therefore, a drilling error due to the board having different thicknesses at different positions may be reduced, the accuracy of back drilling the circuit board is improved. In addition, different types of to-be-back-drilled vias are drilled by performing different back-drilling methods, the accuracy of back drilling different types of to-be-back-drilled vias is improved, a residual stub of the back drilling is highly precisely controlled.

### BRIEF DESCRIPTION OF THE DRAWINGS

In order to more clearly illustrate the technical solutions in the embodiments of the present disclosure, the accompanying drawings for describing the embodiments will be briefly introduced in the following. Obviously, the following described drawings show only some of the embodiments of the present disclosure. Any ordinary skilled person in the art may obtain other drawings based on the shown drawings with making any creative work.
FIG. 1 is a flow chart of a method of back drilling to process a circuit board according to a first embodiment of the present disclosure.
FIG. 2 is a flow chart of a method of back drilling to process a circuit board according to a second embodiment of the present disclosure.
FIG. 3 is a structural schematic view of a circuit board according to a first embodiment of the present disclosure.
FIG. 4 is a flow chart of a method of back drilling to process a circuit board according to a second embodiment of the present disclosure.
FIG. 5 is a structural schematic view of a circuit board according to a second embodiment of the present disclosure.
FIG. 6 is a flow chart of a method of back drilling to process a circuit board according to a third embodiment of the present disclosure.
FIG. 7 is a structural schematic view of a circuit board according to a third embodiment of the present disclosure.

### DETAILED DESCRIPTION

The present disclosure provides a battery protection plate, a processing method, and an electronic device to satisfy heat dissipation needs of the battery protection plate to prolong the service life and improve reliability of the battery protection plate.

In order to make the purpose, technical solutions and advantages of the embodiments of the present disclosure clearer, technical solutions in the embodiments of the present disclosure will be described clearly and completely in the following by referring to the accompanying drawings in the embodiments of the present disclosure. Apparently, the described embodiments are a part of, but not all of, the embodiments of the present disclosure. All other embodiments, which are obtained by any ordinary skilled person in the art based on the embodiments without making creative work, shall fall within the scope of the present disclosure.

The terms "first", "second", and "third" herein are used for descriptive purposes only and shall not be interpreted as indicating or implying relative importance or implicitly specifying the number of technical features indicated. Therefore, a feature defined with "first", "second", "third" may include at least one such feature, either explicitly or implicitly. In the description herein, "plurality" means at least two, such as two, three, and so on, unless otherwise expressly and specifically limited. All directional indications (such as up, down, left, right, front, back, and so on) in the embodiments of the present disclosure are only used to explain the relative positional relationship, movement, and so on, between components in a particular attitude (the attitude shown in the accompanying drawings). If the particular attitude is changed, the directional indications may be changed accordingly. Furthermore, the terms "including", "having", and any variations thereof are intended to cover non-exclusive inclusion. For example, a process, a method, a system, a product or an apparatus including a series of operations or units is not limited to the listed operations or units, but optionally further includes operations or units that are not listed or other operations or units that are inherently included in the process, the method, the system, the product or the apparatus.

The "embodiment" herein implies that particular features, structures, or characteristics described in one embodiment may be included in at least one other embodiments of the present disclosure. The presence of the term at various sections in the specification does not necessarily refer to a same embodiment, nor a separate or an alternative embodiment that is mutually exclusive of other embodiments. Any ordinary skilled person in the art shall understand that, both explicitly and implicitly, the embodiments described herein may be combined with other embodiments without conflict. Each of these embodiments will be described in detail below.

In the present disclosure, a circuit board includes a printed circuit board, a PCB, a flexible printed circuit board, and so on, and may be a multilayer board. When the circuit board is the multilayer board, a thickness of each layer may be uneven. In a process of manufacturing the multilayer board, designing and processing an inner layer pattern and laminating multi-layers may result in the circuit board having an uneven thickness and result in a distance between a surface conductive layer for back drilling and a target signal layer corresponding to a current back drilling operation being uneven. In this case, one back-drilling operation performed based on a predetermined depth may cause a residual stub of the back drilling of the back-drilled via to be excessively long or excessively short, or cause the target signal layer to be drilled through, such that the accuracy of the back drilling may be poor, a loss of signals of the signal via may be large, or may even the via may not function as the signal via properly. Therefore, the present disclosure provides a circuit board and a method of back drilling to process the circuit board. A corresponding target back drilling depth or a target relative height for different back-drilled vias in the circuit board and back-drilling depths of the different back-drilled vias. Further, back drilling is performed based on the target back-drilling depths or the target relative heights to improve the accuracy of back drilling to remove the residual stub.

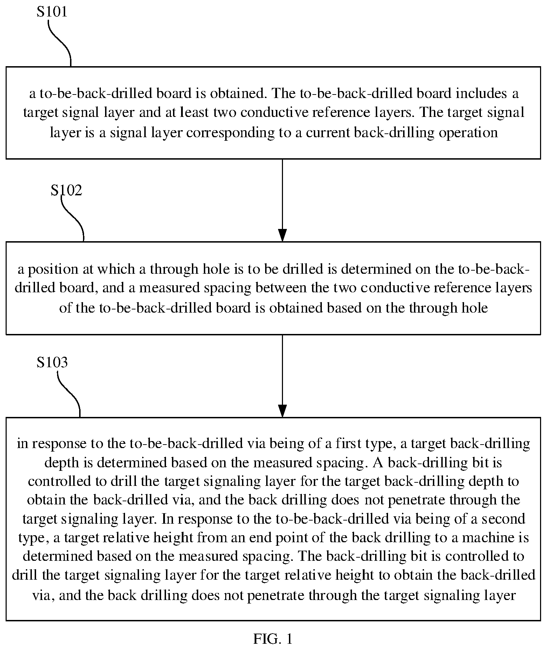

FIG. 1 is a flow chart of the method of back drilling to process the circuit board according to a first embodiment of the present disclosure.

In an operation S101, a to-be-back-drilled board is obtained. The to-be-back-drilled board includes a target signal layer and at least two conductive reference layers. The target signal layer is a signal layer corresponding to a current back-drilling operation.

The conductive reference layers in the present embodiment may be additionally provided or metal conductive layers that are inherently arranged in the circuit, such as a surface conductive layer of the circuit board, a ground layer in the circuit board, a power supply layer, or other signal layers.

It is understood that the circuit board may have a plurality of signal layers. The target signal layer is one of the plurality of signal layers corresponding to the current back drilling operation. Similarly, the at least two conductive reference layers also correspond to the current back drilling operation, instead of any random layers of the circuit board. In other words, for one to-be-back-drilled board, the conductive reference layer in the present operation is not unique or fixed, but each conductive reference layer in the present operation is referring to a back-drilled via of the current back-drilling operation. For different back-drilled vis of different back-drilling operations, the at least two conductive reference layers may refer to different conductive layers or same conductive layers.

In addition, the circuit board may have the plurality of signal layers and have a plurality of different back-drilled vias. The different back-drilled vias may be in different types, such as a single-sided back-drilled via or a double-sided back-drilled via. Alternatively, the back-drilled vias may be classified, based on a predetermined back-drilling depth, into a shallow back-drilled via or a deep back-drilled via.

In an operation S102, a position at which a through hole is to be drilled is determined on the to-be-back-drilled board, and a measured spacing between the two conductive reference layers of the to-be-back-drilled board is obtained based on the through hole.

In the present operation, a through hole is drilled at the position corresponding to the to-be-back-drilled via on the to-be-back-drilled board, and the measured spacing between the two conductive reference layers of the to-be-back-drilled board is obtained based on the through hole. The measured spacing may be the obtained by performing a measurement when the through hole is being drilled. Alternatively, the measured spacing may be the obtained based on relevant signals or data when the through hole is being drilled.

Further, the to-be-back-drilled board may include a plurality of to-be-back-drilled vias. One through hole is defined at the position corresponding to each to-be-back-drilled via, and one measured spacing of the two conductive reference layers corresponding to each to-be-back-drilled via is obtained based on the corresponding through hole. At least two conductive reference layers corresponding to one of the plurality of to-be-back-drilled vias may be the same as or different from at least two conductive reference layers corresponding to another one of the plurality of to-be-back-drilled vias. Therefore, even when two conductive reference layers corresponding to one to-be-back-drilled via is the same as two conductive reference layers corresponding to another to-be-back-drilled via, the measured spacings between the two conductive reference layers corresponding to the one to-be-back-drilled via may be different from the measured spacings between the two conductive reference layers corresponding to the another to-be-back-drilled via. For each to-be-back-drilled via, the measured spacing between the two conductive reference layers is obtained, such that any impact caused by the uneven thickness of the board can be reduced or even eliminated.

Generally, the through hole is drilled at the to-be-back-drilled position of the circuit board, and subsequently, metallization is performed on the through hole to obtain a metal via, such that the back-drilled via is obtained. Through holes are drilled at the predetermined positions corresponding to all to-be-back-drilled vias on the to-be-back-drilled board, and the measured spacing between the two conductive reference layers corresponding to each to-be-back-drilled via is obtained based on the corresponding through hole. Subsequently, metallization is performed on each through hole to obtain the metal via, and an operation of S103 is performed at the position where each metal via is located.

In the operation S103, in response to the to-be-back-drilled via being of a first type, a target back-drilling depth is determined based on the measured spacing. A back-drilling bit is controlled to drill the target signaling layer for the target back-drilling depth to obtain the back-drilled via, and the back drilling does not penetrate through the target signaling layer. In response to the to-be-back-drilled via being of a second type, a target relative height from an end point of the back drilling to a machine is determined based on the measured spacing. The back-drilling bit is controlled to drill the target signaling layer for the target relative height to obtain the back-drilled via, and the back drilling does not penetrate through the target signaling layer.

In the present operation, the target back-drilling depth or the target relative height are controlled based on different types of back-drilled vias. In this way, depth-controlled back drilling is performed to obtain the back-drilled via, the metal residual stub of the back drilling of the back-drilled via is controlled to be within a small length range, and at the same time, the target signaling layer is not penetrated through by the back drilling, such that the signaling layer can perform functions properly.

In the present embodiment, the measured spacing between the two conductive reference layers corresponding to each to-be-back-drilled via is obtained when drilling the corresponding through hole. The target back-drilling depths or the target relative heights for different types of to-be-back-drilled vias are determined based on the measured spacings. Accuracy of the target back-drilling depths or the target relative heights is improved. Back drilling is performed based on the target back-drilling depth or the target relative height. In this way, a drilling error caused by the circuit board having the uneven thickness at different positions may be reduced, and back-drilling precision is improved. Different types of to-be-back-drilled vias are obtained by performing different back drilling methods, such that the back-drilling accuracy of different types to-be-back-drilled vias is improved, and the residual stub of the back drilling is highly precisely controlled.

Specifically, it is determined whether the to-be-back-drilled via is of the first type or the second type. The type of the to-be-back-drilled via may be determined based on a predetermined back-drilling depth of the back-drilled via or based on a distance between the target signal layer and a to-be-back-drilled surface of the circuit board. In the to-be-back-drilled board, a theoretical spacing between the target signal layer and the to-be-back-drilled surface of the circuit board is known and can be calculated based on a thickness of each sub-panel and a thickness of the dielectric layer of the to-be-back-drilled board. In order to prevent the target signal layer from being penetrated through by back drilling, the predetermined back-drilling depth needs to be less than the theoretical spacing between the target signal layer and the to-be-back-drilled surface of the circuit board, and a difference between the predetermined back-drilling depth and the theoretical spacing is equal to the theoretical residual stub of the back drilling.

In an embodiment, the back drilling processing method further includes: obtaining the predetermined back-drilling depth of the back-drilled via in the to-be-back-drilled board. In response to the predetermined back-drilling depth being greater than or equal to a signal detection safety value, the back-drilled via is determined to be of the first type. In response to the predetermined back-drilling depth being less than the signal detection safety value, the back-drilled via is determined to be of the second type.

The signal detection safety value is related to a drilling machine. When the drilling machine is used to drill a hole, the drilling machine can only obtain a signal corresponding to one of the two layers that is firstly contacted by a drilling bit or a drilling needle in response to the spacing between two layers having to-be-obtained signals being less than the signal detection safety value. A signal of the other one of the two layers that is later contacted by the drilling bit or the drilling needle may be abnormal or may be affected or interfered with by the signal of the firstly-contacted layer. Therefore, the spacing that is actually measured between the two layers cannot be obtained. In the present embodiment, the signal detection safety value is greater than or equal to 0.5 mm. Specifically, the signal detection safety value may be 0.8 mm, 1.0 mm, 1.2 mm, 1.4 mm, and so on, depending on the drilling machine for the circuit board.

In response to the predetermined back-drilling depth being greater than or equal to the signal detection safety value, the back-drilled via is determined to be of the first type, which is also referred to as a deep back-drilled via. In response to the predetermined back-drilling depth being less than the signal detection safety value, the back-drilled via is determined to be of the second type, which is referred to as a shallow back-drilled via.

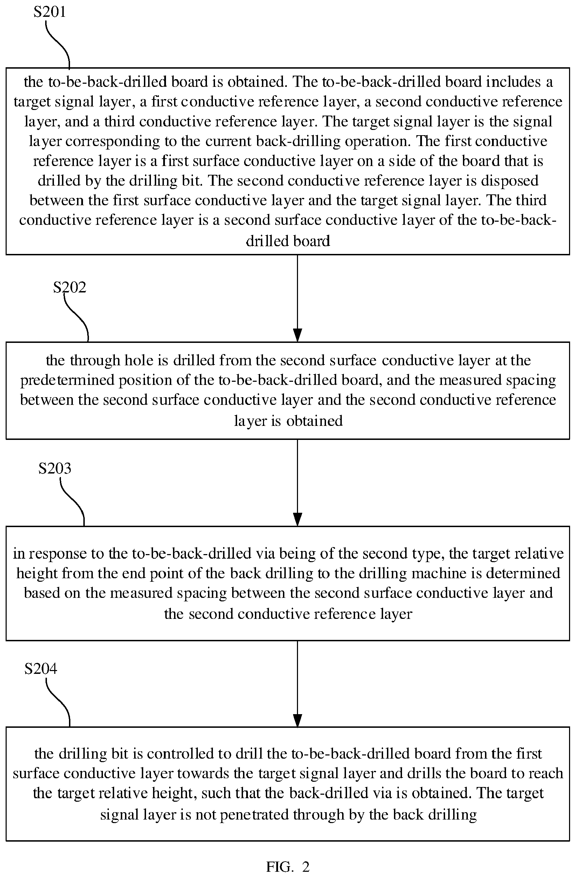

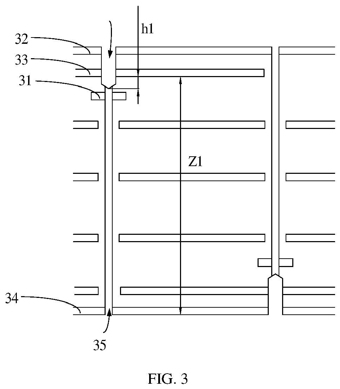

In response to the predetermined back-drilling depth being less than the signal detection safety value, the back-drilled via is determined to be of the second type, and the back drilling processing method for the back-drilled via of the second type may be referred to the method in FIG. 2 and FIG. 3. FIG. 2 is a flow chart of the method of back drilling to process the circuit board according to a second embodiment of the present disclosure, and FIG. 3 is a structural schematic view of the circuit board according to the first embodiment of the present disclosure.

In an operation S201, the to-be-back-drilled board is obtained. The to-be-back-drilled board includes a target signal layer 31, a first conductive reference layer, a second conductive reference layer, and a third conductive reference layer. The target signal layer 31 is the signal layer corresponding to the current back-drilling operation. The first conductive reference layer is a first surface conductive layer 32 on a side of the board that is drilled by the drilling bit. The second conductive reference layer 33 is disposed between the first surface conductive layer 32 and the target signal layer 31. The third conductive reference layer is a second surface conductive layer 34 of the to-be-back-drilled board.

The present operation may be referred to the operation S 101 and will not be repeated here.

In an operation S202, the through hole 35 is drilled from the second surface conductive layer 34 at the predetermined position of the to-be-back-drilled board, and the measured spacing Z1 between the second surface conductive layer 34 and the second conductive reference layer 33 is obtained.

The present operation may be referred to the operation S 102 and will not be repeated here.

In an operation S203, in response to the to-be-back-drilled via being of the second type, the target relative height from the end point of the back drilling to the drilling machine is determined based on the measured spacing Z1 between the second surface conductive layer 34 and the second conductive reference layer 33.

Specifically, the target relative height from the end point of the back drilling to the drilling machine is determined based on the measured spacing Z1 between the second surface conductive layer 34 and the second conductive reference layer 33 and based on a predetermined staged-controlled depth h1 from the second conductive reference layer 33 to the target signal layer 31.

Further, the to-be-back-drilled board may be placed on a pad to be drilled. In this case, the pad is disposed on a side of the second surface conductive layer 34 of the back-drilled board. A height from the pad to the drilling machine can be obtained by the drilling machine. The target relative height from the end point of the back drilling to the drilling machine is determined based on the measured spacing Z1 between the second surface conductive layer 34 and the second conductive reference layer 33 and based on the predetermined staged-controlled depth h1 between the second conductive reference layer 33 and the target signal layer 31 and the height from the pad to the drilling machine.

Specifically, a sum is obtained by adding the height from the pad to the drilling machine, the measured spacing Z1 between the second surface conductive layer 34 and the second conductive reference layer 33, and a compensation value. The target relative height from the end point of back drilling to the drilling machine is determined by subtracting the predetermined staged-controlled depth h1 between the second conductive reference layer 33 and the target signal layer 31 from the sum. The compensation value includes a thickness of plated copper and the difference between the through hole and the relative height of the back-drilling bit of the machine.

In the present embodiment, the relative height with respect to a machine table may be a longitudinal coordinate in a coordinate system of the machine table.

In an operation S204, the drilling bit is controlled to drill the to-be-back-drilled board from the first surface conductive layer 32 towards the target signal layer 31 and drills the board to reach the target relative height, such that the back-drilled via 36 is obtained. The target signal layer is not penetrated through by the back drilling.

Prior to the present operation, the metallization is performed on the through hole 35 to obtain a metal through hole. In the present operation, the drilling bit is controlled to drill, based on an opening of the metal through hole, the to-be-back-drilled board from the first surface conductive layer 32. The drilling bit drills the board to reach the target relative height, i.e., the end point of back drilling.

In the present embodiment, the second conductive reference layer 33 is disposed between the first surface conductive layer 32, which is configured to be drilled from, and the target signal layer 31. The distance between the second conductive reference layer 33 and the first surface conductive layer 32, which is configured to be drilled from, and the distance between the second conductive reference layer 33 and the target signal layer 31 may be determined based on the specific situations. For example, the second conductive reference layer 33 may be disposed closer to the target signal layer 31, and that is, the distance between the second conductive reference layer 33 and the first surface conductive layer 32, which is configured to be drilled from, is greater than the distance between the first surface conductive layer 32 and the target signal layer 31. In this case, since the through hole is actually being drilled, the measured spacing Z1 between the second surface conductive layer 34 and the second conductive reference layer 33 is actually measured based on the through hole. The measured spacing is more accurate. As the predetermined staged-controlled depth h1 from the second conductive reference layer 33 to the target signal layer 31 decreases, the back drilling is less affected by errors in the thickness of the board, and depth control in the back drilling is more accurate.

In the present embodiment, the back-drilled via is of the second type, and that is, the predetermined back-drilling depth is less than the signal detection safety value. A sum of the predetermined back-drilling depth and the predetermined staged-controlled depth h1 from the second conductive reference layer 33 to the target signal layer 31 is the spacing between the first surface conductive layer 32, which is configured to be drilled from, and the target signal layer 31. The predetermined staged-controlled depth h1 is generally very small, the spacing between the first surface conductive layer 32, which is configured to be drilled from, and the second conductive reference layer 33 is less than the signal detection safety value. Therefore, regardless of drilling the through hole in the board by drilling from the first surface conductive layer 32 or from the second surface conductive layer 34, the actually-measured spacing between the first surface conductive layer 32 and the second conductive reference layer 33 is unable to be obtained. Therefore, back drilling cannot be performed based on the predetermined staged-controlled depth h1 from the second conductive reference layer 33 to the target signal layer 31 and based on the measured spacing between the first surface conductive layer 32 and the second conductive reference layer 33. Instead, in the present embodiment, the drilling bit drills the board from the second surface conductive layer 34 to obtain the through hole, such that the actually-measured spacing between the second surface conductive layer 34 and the second conductive reference layer 33 is obtained. Furter, depth-control back drilling is performed based on the target relative height from the end point of the back drilling to the machine. In this way, the back-drilling depth is controlled more accurately, the residual stub of the back drilling is less, and the target signal layer is not penetrated through by the back drilling.

In other embodiments, in addition to to-be-back-drilled vias, the to-be-back-drilled board in the present embodiment further includes another to-be-back-drilled via dispose in a side of the board opposite to the back-drilling direction. The to-be-back-drilled via in the opposite direction may be obtained by performing the operations of the back-drilling processing method in the present embodiment and by drilling a through hole in the opposite direction opposite to the back-drilling direction of in the present embodiment. The measured spacing between the surface conductive layer from which the through hole is drilled and the intermediate conductive reference layer is obtained. The intermediate conductive reference layer is disposed between the surface conductive layer from which the through hole is drilled and the target signal layer. The target relative height from the end point of the back drilling to the machine is obtained based on the measured distance, and the depth-control back drilling is performed based on the target relative height. The depth-control back drilling may be performed more accurately.

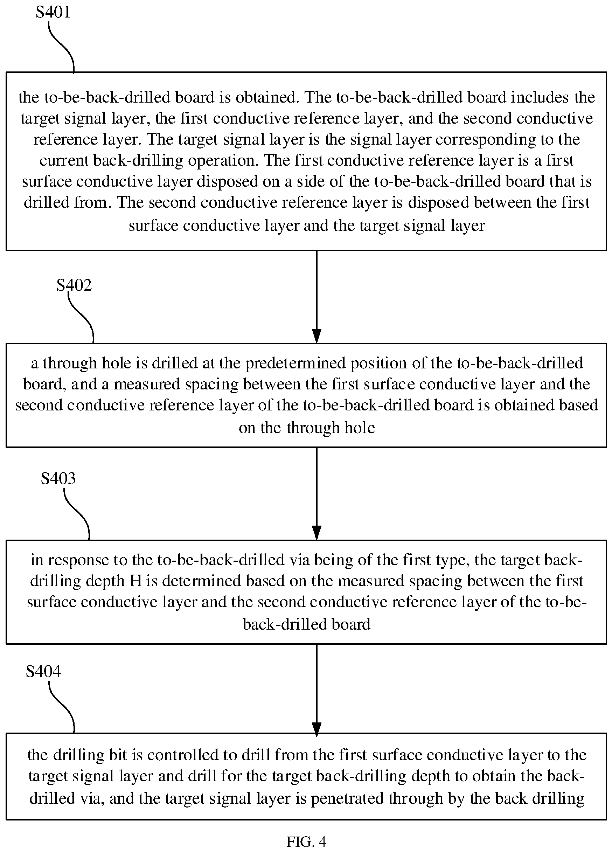

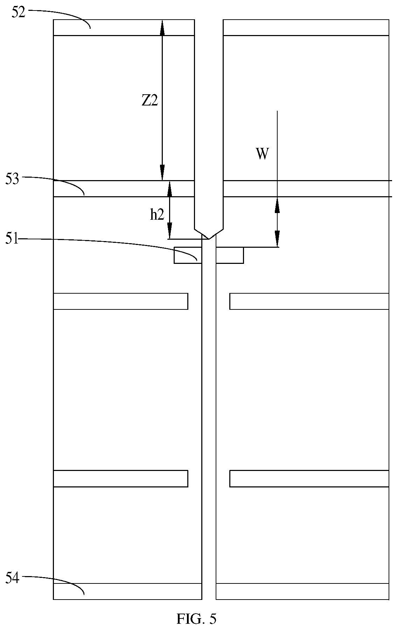

In response to the predetermined back-drilling depth being greater than or equal to the signal detection safety value, the back-drilled via is determined as being of the first type. The back drilling processing method may be specifically referred to the method in FIG. 4 and FIG. 5. FIG. 4 is a flow chart of the method of back drilling to process the circuit board according to a second embodiment of the present disclosure, and FIG. 5 is a structural schematic view of the circuit board according to the second embodiment of the present disclosure.

In an operation S401, the to-be-back-drilled board is obtained. The to-be-back-drilled board includes the target signal layer 51, the first conductive reference layer, and the second conductive reference layer 53. The target signal layer 51 is the signal layer corresponding to the current back-drilling operation. The first conductive reference layer is a first surface conductive layer 52 disposed on a side of the to-be-back-drilled board that is drilled from. The second conductive reference layer 53 is disposed between the first surface conductive layer 52 and the target signal layer 51.

The present operation can be referred to the operation S 101 and will not be repeated here.

In an operation S402, a through hole is drilled at the predetermined position of the to-be-back-drilled board, and a measured spacing Z2 between the first surface conductive layer 52 and the second conductive reference layer 53 of the to-be-back-drilled board is obtained based on the through hole.

In an operation S403, in response to the to-be-back-drilled via being of the first type, the target back-drilling depth H is determined based on the measured spacing Z2 between the first surface conductive layer 52 and the second conductive reference layer 53 of the to-be-back-drilled board.

Specifically, in response to the to-be-back-drilled via being of the first type, the target back-drilling depth H is determined based on the measured spacing Z2 between the first surface conductive layer 52 and the second conductive reference layer 53 of the to-be-back-drilled board and based on the predetermined staged-controlled depth h2 from the second conductive reference layer 53 to the target signal layer 51. Further, the target back-drilling depth H is the sum of the measured spacing Z2 and the predetermined staged-controlled depth h2. That is, the following formula is satisfied: Target back drilling depth H = measured spacing Z2 + predetermined staged-controlled depth h2.

In an embodiment, the to-be-back-drilled board further includes a second surface conductive layer 54. In the operation S402, a measured spacing between the first surface conductive layer 52 and the second surface conductive layer 54 is further obtained based on the through hole. A board thickness ratio value x is obtained based on the measured spacing between the first surface conductive layer 52 and the second surface conductive layer 54 and the theoretical thickness of the to-be-back-drilled board. Specifically, the board thickness ratio value x is a ratio of the measured spacing between the first surface conductive layer 52 and the second surface conductive layer 54 to the theoretical thickness of the to-be-back-drilled board. In the operation S403, the target back-drilling depth H is determined based on the measured spacing Z2 between the first surface conductive layer 52 and the second conductive reference layer 53 of the to-be-back-drilled board, based on the predetermined staged-controlled depth h2 from the second conductive reference layer 53 to the target signal layer 51, and based on the board thickness ratio value x. Specifically, the target back-drilling depth H is a sum of the predetermined staged-controlled depth h2 from the second conductive reference layer 53 to the target signal layer 51, the board thickness ratio value x, and the measured spacing Z2 between the first surface conductive layer 52 and the second conductive reference layer 53.

In the present embodiment, the errors of the dielectric layer thickness and the board thickness corresponding to the predetermined staged-controlled depth h2 are reduced or even eliminated due to the board thickness ratio value x, such that the target back drilling depth H is more accurate, depth-controlled back drilling can be performed more precisely.

In an operation S404, the drilling bit is controlled to drill from the first surface conductive layer 52 to the target signal layer 51 and drill for the target back-drilling depth to obtain the back-drilled via, and the target signal layer is penetrated through by the back drilling.

In the present embodiment, the back-drilled via is of the first type. That is, the predetermined back-drilling depth is greater than or equal to the signal detection safety value. The theoretical spacing between the first surface conductive layer 52 and the second conductive reference layer 53 needs to be greater than the signal detection safety value, otherwise, according to the back-drilling method of the previous embodiment, the back-drilled via may be classified as the second type.

In the present embodiment, the measured spacing Z2 between the first surface conductive layer 52 and the second conductive reference layer 53 is obtained based on the through hole, and the target back-drilling depth H is determined based on the measured spacing Z2 and the predetermined staged-controlled depth h2 from the second conductive reference layer 53 to the target signal layer 51. In this way, accuracy and precision of the target back-drilling depth H is improved, drilling errors due to the thickness of the board are reduced, accuracy of the back drilling is improved, and accuracy of the current the back-drilling task is achieved. The residual stub of the back drilling is better controlled within a suitable range, and the target signal layer is not penetrated through by the back drilling. Further, the board thickness ratio value x is obtained, and the errors of the dielectric layer thickness and the board thickness corresponding to the predetermined staged-controlled depth h2 are reduced or even eliminated, such that the target back-drilling depth H is more accurate, and more accurate depth-controlled back drilling is achieved.

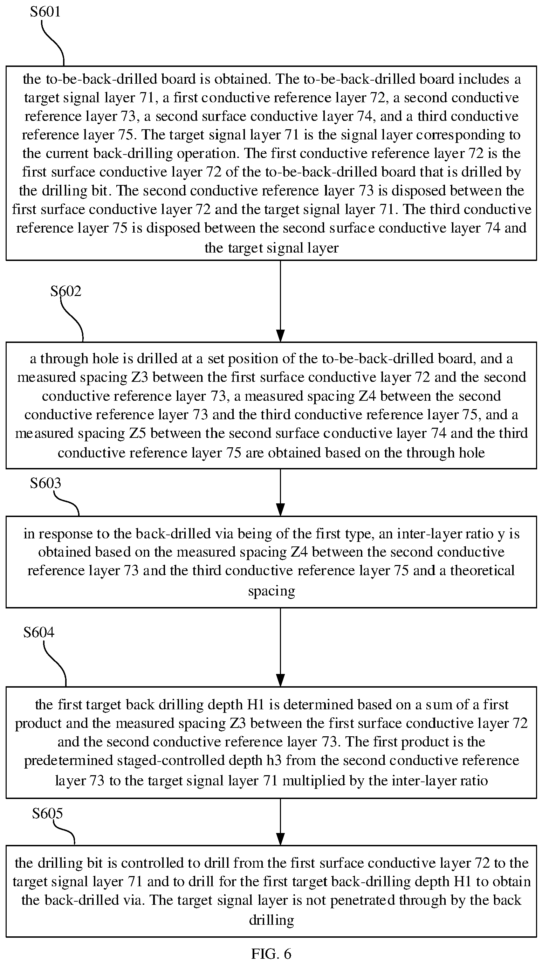

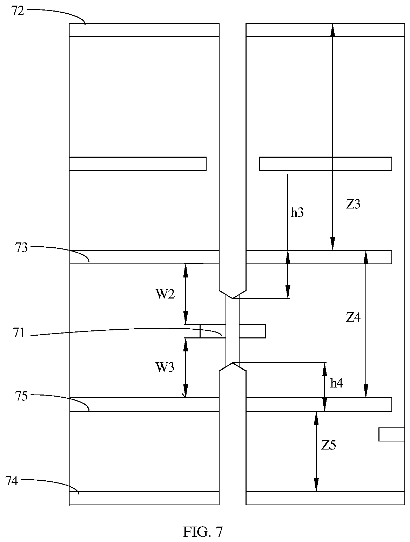

As shown in FIG. 6 and FIG. 7, FIG. 6 is a flow chart of the method of back drilling to process the circuit board according to a third embodiment of the present disclosure, FIG. 7 is a structural schematic view of the circuit board according to the third embodiment of the present disclosure.

In an operation S601, the to-be-back-drilled board is obtained. The to-be-back-drilled board includes a target signal layer 71, a first conductive reference layer 72, a second conductive reference layer 73, a second surface conductive layer 74, and a third conductive reference layer 75. The target signal layer 71 is the signal layer corresponding to the current back-drilling operation. The first conductive reference layer 72 is the first surface conductive layer 72 of the to-be-back-drilled board that is drilled by the drilling bit. The second conductive reference layer 73 is disposed between the first surface conductive layer 72 and the target signal layer 71. The third conductive reference layer 75 is disposed between the second surface conductive layer 74 and the target signal layer 71.

In an operation S602, a through hole is drilled at a set position of the to-be-back-drilled board, and a measured spacing Z3 between the first surface conductive layer 72 and the second conductive reference layer 73, a measured spacing Z4 between the second conductive reference layer 73 and the third conductive reference layer 75, and a measured spacing Z5 between the second surface conductive layer 74 and the third conductive reference layer 75 are obtained based on the through hole.

In an operation S603, in response to the back-drilled via being of the first type, an inter-layer ratio y is obtained based on the measured spacing Z4 between the second conductive reference layer 73 and the third conductive reference layer 75 and a theoretical spacing.

Specifically, the inter-layer ratio y is obtained based on a ratio of the measured spacing Z4 between the second conductive reference layer 73 and the third conductive reference layer 75 to the theoretical spacing between the second conductive reference layer 73 and the third conductive reference layer 75. The theoretical spacing between the second conductive reference layer 73 and the third conductive reference layer 75 may be determined based on the theoretical board thickness and the theoretical dielectric layer thickness.

In an operation S604, the first target back drilling depth H1 is determined based on a sum of a first product and the measured spacing Z3 between the first surface conductive layer 72 and the second conductive reference layer 73. The first product is the predetermined staged-controlled depth h3 from the second conductive reference layer 73 to the target signal layer 71 multiplied by the inter-layer ratio.

Further, the first target back-drilling depth H1 may be determined based on a sum of the first product, the measured spacing Z3 between the first surface conductive layer 72 and the second conductive reference layer 73, and a compensation value. The first product is the predetermined staged-controlled depth h3 from the second conductive reference layer 73 to the target signal layer 71 multiplied by the inter-layer ratio. The compensation value includes a thickness of plated copper and the difference between the through hole and the relative height of the back-drilling bit of the machine.

In an operation S605, the drilling bit is controlled to drill from the first surface conductive layer 72 to the target signal layer 71 and to drill for the first target back-drilling depth H1 to obtain the back-drilled via. The target signal layer is not penetrated through by the back drilling.

Further, the back-drilling processing method of the present embodiment further includes the following. A second target back-drilling depth H2 is determined based on a sum of the measured spacing Z5 between the second surface conductive layer 74 and the third conductive reference layer 75 and a second product. The second product is the predetermined staged-controlled depth h4 from the third conductive reference layer 75 to the target signal layer 71 multiplied by the inter-layer ratio y. The drilling bit is controlled to drill from the second surface conductive layer 74 towards the target signal layer 71 for the second target back-drilling depth H2 to obtain a second target back-drilled via. The target signal layer is not penetrated through by the back drilling. The inter-layer ratio y herein is the inter-layer ratio y obtained in the operation S603.

Double-sided back-drilled vias are obtained by drilling from the first surface conductive layer 72 towards the target signal layer 71 and drilling from the second surface conductive layer 74 towards the target signal layer 71.

In the present embodiment, the double-sided back-drilled vias are both of the first type. That is, the predetermined back-drilling depth on each of the two sides is greater than or equal to the signal detection safety value. The theoretical spacing between the first surface conductive layer 72 and the second conductive reference layer 73 needs to be greater than the signal detection safety value. The theoretical spacing between the second surface conductive layer 74 and the third conductive reference layer 75 needs to be greater than the signal detection safety value. When the back drilling performed on either side cannot satisfy the above conditions, the back drilling on the corresponding side is performed according to the back drilling method of the second type of the back-drilled via.

In the present embodiment, the second surface conductive layer 74 is disposed between the first surface conductive layer 72 and the target signal layer 71, the third conductive reference layer 75 is disposed between the second surface conductive layer 74 and the target signal layer 71, and the through hole is drilled. The measured spacing Z3 between the first surface conductive layer 72 and the second conductive reference layer 73, the measured spacing Z4 between the second surface conductive layer 73 and the third conductive reference layer 75, and the measured spacing Z5 between the second surface conductive layer 73 and the third conductive reference layer 75 are obtained based on the through hole. The inter-layer ratio y is obtained based on the ratio of the measured spacing Z4 between the second conductive reference layer 73 and the third conductive reference layer 75 to the theoretical spacing therebetween. The first target back-drilling depth H1 and the second target back-drilling depth H2 are obtained more accurately based on the above data. The board is drilled from the first surface conductive layer 72 towards the target signal layer 71 and from the second surface conductive layer 74 towards the target signal layer 71. Depth-controlled back drilling is performed based on the first target back-drilling depth H1 and the second target back-drilling depth H2, respectively, to obtain the double-sided back-drilled vias. The errors of the dielectric layer thickness and the board thickness corresponding to the predetermined staged-controlled depth h3 and the predetermined staged-controlled depth h4 are reduced or even eliminated, due to the measured spacing Z3 and the measured spacing Z5, which are obtained by being actually measured, and the inter-layer ratio y. In this way, the target back-drilling depth H is more accurate, and more accurate depth-controlled back drilling is achieved.

In the above embodiment, the spacing between the target signal layer and the inner conductive reference layer may be referred to as a back-drilling safety spacing W. The back-drilling safety spacing W needs to be greater than or equal to a sum of the residual stub of the back drilling and a voltage safety design value, such as greater than or equal to 0.45 mm. The voltage design safety value may be referred to as a voltage safety distance and is related to conditions, such as voltages, temperatures, and humidity, of the circuit board while in use. The voltage safety design value is determined to prevent the spacing between the target signal layer and the inner conductive reference layers of the circuit board from being excessively short, when the circuit board is under specific voltage conditions, specific temperature conditions, and specific humidity conditions. In other words, when the spacing between the residual stub of back drilling of the target signal layer and the inner conductive reference layer is excessively short, voltage breakdown may occur, and electrons may migrate between the target signal layer and the inner conductive reference layer to form a channel, resulting in a short circuit. The voltage design safety value may be 0.1mm, 0.3mm, 0.5mm, and so on, and may be determined based on the actual circuit boards, which will not be limited here.

For the double-sided back-drilled vias, the spacing between the target signal layer and the inner conductive reference layer on one of the two sides is a safe back-drilling distance W2, and the spacing between the target signal layer and the inner conductive reference layer on the other one of the two sides is a safe back-drilling distance W3. Each of the safe back-drilling distance W2 and the safe back-drilling distance W3 needs to satisfy the back-drilling safety distance. For the double-sided back-drilled vias, in order to obtain the measured spacing between the two inner conductive reference layers, the spacing between the two inner conductive reference layers needs to be greater than or equal to a signal detection safety value K. In other words, the double-sided back-drilled vias needs to satisfy the following: the back-drilling safety distance W2 ≥ K/2 and the back-drilling safety distance W3 ≥ K/2. The K is the signal detection safety value. A sum of the back-drilling safety distance W2 and the back-drilling safety distance W3 is approximately equal to the spacing between the two inner conductive reference layers. As the spacing between the target signal layer and the inner conductive reference layer and the safety distance W are smaller, the control accuracy of the back drilling may be greater, as long as the spacing and the safety distance W satisfy certain conditions.

It is understood that when the to-be-back-drilled board includes the above-described plurality of to-be-back-drilled vias, corresponding back-drilling operations may be performed according to corresponding back-drilling processing methods, respectively, such that the controlled depth or the relative height can be calculated based on each to-be-back-drilled via and the type of each to-be-back-drilled via, and accurate back-drilling is achieved.

The present disclosure further provides a circuit board, obtained by performing the back drilling processing method of the present disclosure. When drilling through holes, the measured spacing between the two conductive reference layers corresponding to the holes is obtained. The target back-drilling depth or the target relative height is determined for different types of to-be-back-drilled vias based on the measured spacing. The accuracy of the target back-drilling depth or the target relative height is improved. Back-drilling is performed based on the target back-drilling depth or the target relative height. Drilling errors due to the board having the uneven thicknesses at different locations are reduced, and the back-drilling accuracy is improved. Corresponding back-drilling methods are performed for different types of to-be-back-drilled vias. Therefore, the back-drilling accuracy for different types of to-be-back-drilled vias is improved. The residual stub of the back drilling is highly precisely controlled. In addition, the circuit board having a highly-precise back-drilled residual stub is obtained.

The above shows only embodiments of the present disclosure, and is not intended to limit the scope of the present disclosure. Any equivalent structure or equivalent process transformation performed based on the contents of the specification and the accompanying drawings of the present disclosure, applied directly or indirectly in other related technical fields, shall be similarly included in the scope of the present disclosure.

## Claims

1. A back drilling processing method for a circuit board, comprising:
obtaining a to-be-back-drilled board, wherein the to-be-back-drilled board comprises a target signal layer and at least two conductive reference layers; the target signal layer is a signal layer corresponding to a current back-drilling operation;
drilling a through hole at a predetermined position of the to-be-back-drilled board; obtaining, based on the through hole, a measured spacing between two of the at least two conductive reference layers of the to-be-back-drilled board;
determining, in response to a to-be-back-drilled via being of a first type, a target back-drilling depth based on the measured spacing; controlling a drilling bit to drill for the target back-drilling depth towards the target signal layer to obtain a back-drilled via without penetrating through the target signal layer; and
determining, in response to the to-be-back-drilled via being of a second type, a target relative height from an end point of back drilling to a machine based on the measured spacing; controlling the drilling bit to drill towards the target signal layer for the target relative height to obtain the back-drilled via without penetrating through the target signal layer.

2. The back drilling processing method according to claim 1, further comprising:
obtaining a predetermined back-drilling depth of the to-be-back-drilled via in the to-be-back-drilled board;
determining, in response to the predetermined back-drilling depth being greater than or equal to a signal detection safety value, that the to-be-back-drilled via is of the first type;
determining, in response to the predetermined back-drilling depth being less than the signal detection safety value, that the to-be-back-drilled via is of the second type.

3. The back drilling processing method according to claim 2, wherein,
the to-be-back-drilled board comprises a first conductive reference layer, a second conductive reference layer, and a third conductive reference layer; the first conductive reference layer is a first surface conductive layer disposed on a side of the to-be-back-drilled board from which the drilling bit drills, the second conductive reference layer is disposed between the first surface conductive layer and the target signal layer, and the third conductive reference layer is a second surface conductive layer of the to-be-back-drilled board;
the drilling a through hole at a predetermined position of the to-be-back-drilled board; obtaining, based on the through hole, a measured spacing between two of the at least two conductive reference layers of the to-be-back-drilled board, comprises:
drilling from the second surface conductive layer at the predetermined position of the to-be-back-drilled board to obtain the through hole; and obtaining a measured spacing between the second surface conductive layer and the second conductive reference layer;
the determining, in response to the to-be-back-drilled via being of a second type, a target relative height from an end point of back drilling to a machine based on the measured spacing; controlling the drilling bit to drill towards the target signal layer for the target relative height to obtain the back-drilled via without penetrating through the target signal layer, comprises:
determining, based on the measured spacing between the second surface conductive layer and the second conductive reference layer, the target relative height from the end point of the back drilling to the machine in response to the to-be-back-drilled via being of the second type; and
controlling the drilling bit to enter the to-be-back-drilled board from the first surface conductive layer to drill towards the target signal layer, drilling for the target relative height, to obtain the back-drilled via, wherein the target signal layer is not penetrated through by back drilling.

4. The back drilling processing method according to claim 3, wherein, the determining, based on the measured spacing between the second surface conductive layer and the second conductive reference layer, the target relative height from the end point of the back drilling to the machine in response to the to-be-back-drilled via being of the second type, comprises:
determining, based on the measured spacing between the second surface conductive layer and the second conductive reference layer and a predetermined staged-controlled depth from the second conductive reference layer to the target signal layer, the target relative height from the end point of back drilling to the machine in response to the to-be-back-drilled via being of the second type.

5. The back drilling processing method according to claim 4, wherein a pad is arranged on a side of the to-be-back-drilled board where the second surface conductive layer is disposed; and
the determining, based on the measured spacing between the second surface conductive layer and the second conductive reference layer, the target relative height from the end point of back drilling to the machine in response to the to-be-back-drilled via being of the second type, comprises:
determining the target relative height from the end point of back drilling to the machine based on the measured spacing between the second surface conductive layer and the second conductive reference layer, the predetermined staged-controlled depth from the second conductive reference layer to the target signal layer, and a height from the pad to the machine.

6. The back drilling processing method according to claim 5, wherein the determining, based on the measured spacing between the second surface conductive layer and the second conductive reference layer, the target relative height from the end point of back drilling to the machine in response to the to-be-back-drilled via being of the second type, comprises:
determining the target relative height from the end point of back drilling to the machine by subtracting the predetermined staged-controlled depth from the second conductive reference layer to the target signal layer from a sum of the height from the pad to the machine, the measured spacing between the second surface conductive layer and the second conductive reference layer, and a compensation value.

7. The back drilling processing method according to claim 2, wherein,
the to-be-back-drilled board comprises a first conductive reference layer and a second conductive reference; the first conductive reference layer is a first surface conductive layer disposed on a side of the to-be-back-drilled board from which the drilling bit drills; the second conductive reference layer is disposed between the first surface conductive layer and the target signal layer;
the drilling a through hole at a predetermined position of the to-be-back-drilled board; obtaining, based on the through hole, a measured spacing between two of the at least two conductive reference layers of the to-be-back-drilled board, comprises:
drilling the through hole at the predetermined position of the to-be-back-drilled board; and obtaining, based on the through hole, a measured spacing between the first surface conductive layer and the second conductive reference layer of the to-be-back-drilled board;
the determining, in response to a to-be-back-drilled via being of a first type, a target back-drilling depth based on the measured spacing; controlling a drilling bit to drill for the target back-drilling depth towards the target signal layer to obtain a back-drilled via without penetrating through the target signal layer, comprises:
determining the target back-drilling depth, in response to the to-be-back-drilled via being of the first type, based on the measured spacing between the first surface conductive layer and the second conductive reference layer of the to-be-back-drilled board;
controlling the drilling bit to drill from the first surface conductive layer towards the target signal layer, drilling for the target back-drilling depth, to obtain the back-drilled via, wherein the target signal layer is not penetrated through by the back drilling.

8. The back drilling processing method according to claim 7, wherein the determining the target back-drilling depth, in response to the to-be-back-drilled via being of the first type, based on the measured spacing between the first surface conductive layer and the second conductive reference layer of the to-be-back-drilled board, comprises:
determining, based on the measured spacing between the first surface conductive layer and the second conductive reference layer and a predetermined staged-controlled depth from the second conductive reference layer to the target signal layer, the target back-drilling depth in response to the to-be-back-drilled via being of the first type.

9. The back drilling processing method according to claim 8, wherein,
the to-be-back-drilled board further comprises a second surface conductive layer;
the drilling a through hole at a predetermined position of the to-be-back-drilled board; obtaining, based on the through hole, a measured spacing between two of the at least two conductive reference layers of the to-be-back-drilled board, comprises:
drilling the through hole at the predetermined position of the to-be-back-drilled board; and obtaining, based on the through hole, the measured spacing between the first surface conductive layer and the second conductive reference layer of the to-be-back-drilled board, and the measured spacing between the first surface conductive layer and the second surface conductive layer of to-be-back-drilled board;
the determining the target back-drilling depth, in response to the to-be-back-drilled via being of the first type, based on the measured spacing between the first surface conductive layer and the second conductive reference layer of the to-be-back-drilled board, comprises:
obtaining a board thickness ratio based on the measured spacing between the first surface conductive layer and the second surface conductive layer and a theoretical board thickness of the to-be-back-drilled board; and
in response to the to-be-back-drilled via being of the first type, determining the target back-drilling depth based on a sum of a first product and a sum of the measured spacing between the first surface conductive layer and the second conductive reference layer, wherein the first product is the predetermined staged-controlled depth from the second conductive reference layer to the target signal layer multiplied by the board thickness ratio.

10. The back drilling processing method according to claim 7, wherein the to-be-back-drilled board further comprises a third conductive reference layer and a second surface conductive layer, the third conductive reference layer is disposed between the second surface conductive layer and the target signal layer;
the drilling a through hole at a predetermined position of the to-be-back-drilled board; obtaining, based on the through hole, a measured spacing between two of the at least two conductive reference layers of the to-be-back-drilled board, comprises:
drilling the through hole at the predetermined position of the to-be-back-drilled board; obtaining, based on the through hole, the measured spacing between the first surface conductive layer and the second conductive reference layer, a measured spacing between the second conductive reference layer and the third conductive reference layer, and a measured spacing between the second surface conductive layer and the third conductive reference layer;
the determining, based on the measured spacing between the first surface conductive layer and the second conductive reference layer and a predetermined staged-controlled depth from the second conductive reference layer to the target signal layer, the target back-drilling depth in response to the to-be-back-drilled via being of the first type, comprises:
in response to the to-be-back-drilled via being of the first type, obtaining an inter-layer ratio based on the measured spacing between the second conductive reference layer and the third conductive reference layer and a theoretical spacing between the second conductive reference layer and the third conductive reference layer; and
determining a first target back-drilling depth based on a sum of a first product and the measured spacing between the first surface conductive layer and the second conductive reference layer, wherein the first product is the predetermined staged-controlled depth from the second conductive reference layer to the target signal layer multiplied by the inter-layer ratio; and
controlling the drilling bit to drill from the first surface conductive layer towards the target signal layer, drilling for the target relative height, without penetrating through the target signal layer, comprises:
controlling the drilling bit to drill from the first surface conductive layer to the target signal layer, drilling for the first target back-drilling depth, to obtain the back-drilled via, wherein the target signal layer is not penetrated through by the back drilling.

11. The back drilling processing method according to claim 10, wherein the determining, based on the measured spacing between the first surface conductive layer and the second conductive reference layer and a predetermined staged-controlled depth from the second conductive reference layer to the target signal layer, the target back-drilling depth in response to the to-be-back-drilled via being of the first type, comprises:
determining a second target back-drilling depth based on a sum of a second product and the measured spacing between the second surface conductive layer and the third conductive reference layer, wherein the second product is a predetermined staged-controlled depth from the third conductive reference layer to the target signal layer multiplied by the inter-layer ratio; controlling the drilling bit to drill towards the target signal layer for the target back-drilling depth to obtain the back-drilled via without penetrating through the target signal layer, comprises:
controlling the drilling bit to drill from the second surface conductive layer towards the target signal layer, drilling for the second target back-drilling depth, to obtain the back-drilled via, wherein the target signal layer is not penetrated through by the back drilling.

12. The back drilling processing method according to claim 10, wherein the measured spacing between the second conductive reference layer and the third conductive reference layer is greater than or equal to a signal detection safety value.

13. The back drilling processing method according to claim 1, wherein the to-be-back-drilled board comprises a plurality of to-be-back-drilled vias; and
the obtaining a to-be-back-drilled board, wherein the to-be-back-drilled board comprises a target signal layer and at least two conductive reference layers; the target signal layer is a signal layer corresponding to a current back-drilling operation, comprises:
obtaining the to-be-back-drilled board, wherein each of the plurality of to-be-back-drilled vias corresponds to one target signal layer and at least two conductive reference layers; and the target signal layer is a signal layer corresponding to the current back-drilling operation.

14. The back drilling processing method according to claim 13, wherein the drilling a through hole at a predetermined position of the to-be-back-drilled board; obtaining, based on the through hole, a measured spacing between two of the at least two conductive reference layers of the to-be-back-drilled board, comprises:
drilling one through hole at a predetermined position corresponding to each of the plurality of to-be-back-drilled vias; and obtaining a measured spacing of two of the at least two conductive reference layers for each of the plurality of to-be-back-drilled vias.

15. The back drilling processing method according to claim 1, wherein, after the drilling a through hole at a predetermined position of the to-be-back-drilled board; obtaining, based on the through hole, a measured spacing between two of the at least two conductive reference layers of the to-be-back-drilled board, the method further comprises:
performing metallization on the through hole to obtain a metal hole.

16. The back drilling processing method according to claim 15, wherein the controlling the drilling bit to drill towards the target signal layer for the target back-drilling depth to obtain the back-drilled via without penetrating through the target signal layer, comprises:
controlling drilling bit to drill, at a position where the metal hole is disposed, towards the target signal layer, drilling for the target back-drilling depth, to obtain the back-drilled via without penetrating through the target signal layer.

17. The back drilling processing method according to claim 16, wherein the controlling the drilling bit to drill towards the target signal layer for the target relative height to obtain the back-drilled via without penetrating through the target signal layer, comprises:
controlling drilling bit to drill, at the position where the metal hole is disposed, towards the target signal layer, drilling for the target relative height, to obtain the back-drilled via without penetrating through the target signal layer.

18. The back drilling processing method according to claim 1, wherein the target relative height from the end point of back drilling to the machine is a longitudinal coordinate of the end point of back drilling in a coordinate system of the machine.

19. The back drilling processing method according to any one of claims 2 to 18, wherein the signal detection safety value is greater than or equal to 0.5 mm.

20. A circuit board, obtained by performing the back drilling processing method according to any one of claims 1-19.
